# EUROPEAN PATENT SPECIFICATION

(11) **EP 1 213 765 B1**
(45) Date of publication and mention of the grant of the patent: **14.03.2007**
(21) Application number: 01126293.8
(22) Date of filing: 06.11.2001
(51) Int. Cl.: H01L 27/148, H01L 31/0216

(54) **Solid state imaging device**
Festkörper-Bildaufnahmevorrichtung
Capteur d'image à l'état solide

(30) Priority: 22.11.2000 JP 2000355200
(43) Date of publication of application: 12.06.2002
(73) Proprietor: SHIMADZU CORPORATION, Kyoto 604-8511 (JP)
(72) Inventor: Takubo, Kenji, Nakagyo-ku, Kyoto 604-8511 (JP)
(74) Representative: Wilhelms . Kilian & Partner Patentanwälte

(56) References cited:
- EP-A- 0 285 084
- EP-A- 0 650 198
- EP-A- 0 653 881
- EP-A- 0 866 502
- EP-A- 0 954 032

## Description

The present invention relates to a solid state imaging device, especially that suitable for taking still pictures or movies of objects in scientific measurements such as a fast moving object, an explosion, a destruction or collapse, a turbulent flow, an electrical discharge, micro-organisms in a microscopic field, phenomena associated with a signal transmission in the brain and nervous system, etc.

### BACKGROUND OF THE INVENTION

In a solid state imaging device, the image to be taken is divided into a two-dimensional array of small areas called pixels, and the part of the image in each pixel is converted into an electrical signal. That is, a photoelectrical conversion takes place in the sensing area of each pixel so that the part of the image is converted to electrical charges and the charges are accumulated. The electrical charges of all the pixels composing an image are read (taken) out serially in a predetermined order, which makes an image signal. In using the solid state imaging device, the X-Y address method and the charge transfer method are known.

In the X-Y address method, electrical charges accumulated in every pixel are read (taken) out from pixel to pixel in a horizontal scanning line, and then the process is switched to the next horizontal scanning line where the same process is repeated to read (take) out the charges of the pixels. Thus the electrical charges of the pixels composing the X-Y matrix are read (taken) out.

In the charge transfer method, a transfer line composed of transfer cells is provided for each line of an X-Y array of pixels. Electrical charges accumulated in pixels of a line are first transferred to corresponding transfer cells, and the electrical charges are then transferred through neighboring cells in the transfer line. At the end of the transfer line, the electrical charges are read (taken) out and an image signal is composed.

A typical example of a solid state imaging device using the charge transfer method is the charge coupled device (CCD). In a CCD, electrical charges are produced by an incident light in a light receiving cell, and accumulated in a potential well provided in the semiconductor. The potential wells are driven one by one by an externally applied transfer voltage so that the electrical charges are transferred through neighboring potential wells. Thus in a CCD, photo sensors and transfer or scanning mechanism are integrated in a chip.

When an image is cast on a CCD and the pixel signal or electrical charges produced in every pixel of the CCD are transferred to the signal output terminal, the pixel signals from remote pixels are likely to be contaminated by other pixel signals on the transfer route. In this case, the electrical image thus taken has smears in those areas. In order to avoid that, in a CCD image sensor, the light receiving cells and the transfer (or scanning) cells are separated. In designing a CCD image sensor for movies, the frame transfer (FT) method, the interline transfer (IT) method and the frame interline transfer (FIT) method are used.

In the FT method, a photosensor section and an accumulation section are provided in each pixel. The electrical charges carrying the signal corresponding to the brightness of an image on every pixel are accumulated in the potential well of the photosensor section of the pixel. Within a very short time of the vertical blanking period, the accumulated signal charges in all the pixels are transferred at one time to the accumulating section. That is, the pattern of the signal charges (which constitutes an image) is transferred as it is from the photosensor section to the accumulation section in parallel. Then the electrical charges in the accumulation sections in the pixels of a horizontal line (pixel line) are transferred to the lower pixel line of the CCD in a horizontal scanning period. After the line transfer toward the lower pixel line is carried out one by one, the electrical charges that have reached the lowest pixel line of the CCD are transferred to the output section with a high speed horizontal scanning.

In the IT method, a photodiode is provided to each of the pixels. The electrical charges produced in the photodiodes of the CCD image sensor are accumulated in the photodiodes in a frame period or in a field period. The signal charges as a whole are transferred at one time via vertical transfer gates to cells of a vertical CCD. After that, the electrical charges of the vertical CCD are transferred to the output section as in the FT method.

The FIT method is a combination of the FT method and the IT method.

Documents EP-A-0 285 084 and EP-A-0 650 198 disclose solid state imaging devices with a light shield.

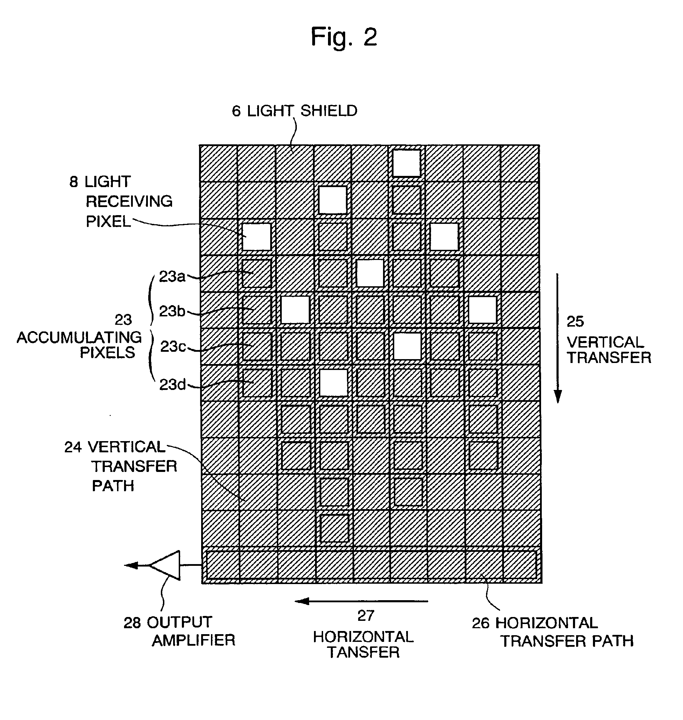

Fig. 2 shows an example of the solid state imaging device based on an FT-CCD. The solid state imaging device includes 3 (three) by 3 (three) pixels and 4 (four) frame recording capacity. In the solid state imaging device, a light shield 6 (hatching area in Fig. 2) is provided over the device to shut off light entering the accumulating pixels 23 (23a, 23b, 23c, 23d) which has apertures at the light receiving pixels 8. For the convenience of the manufacturing process, the light shield 6 is normally made of metal, such as aluminum, which is also used to provide surface wiring. The size of the shielding area increases as the number of storable frames increases, but it normally occupies more than 50% of the whole area. Four accumulating pixels 23 (23a, 23b, 23c, 23d) are placed in a vertical column below a receiving pixel 8, and a vertical transfer path 24 is provided downward from the lower end 23d of the accumulating pixels. The arrow 25 indicates the vertical transfer direction. A horizontal transfer path 26 is provided at the bottom of the vertical transfer paths 24. The arrow 27 indicates the horizontal transfer direction. An end of the horizontal transfer path 26 is connected to an output amplifier 28.

In this configuration, more than two accumulating pixels (in the case of Fig. 2, four accumulating pixels) 23 are provided to each of the light receiving pixels 8. Thus, several (four in the case of Fig. 2) frames of a movie captured at different time points can be recorded and stored in the imaging device. In the solid state imaging device, which is called a peripheral recording type, signal electrical charges are read out after a plurality of frames have been recorded, so that a high speed continuous movie recording is possible without being restricted by the reading out time.

In the conventional solid state imaging devices described above, there appear deleterious phenomena called blooming and smear. In both cases, when an intense light strikes a small spot of an imaging device, a vertical band having a slightly larger width than that of the spot appears.

Blooming is the phenomenon in which, when a strong light strikes a spot of one or more photoelectric converting cells of a CCD or MOS type sensor, the signal electrical charges generated there pour out of the potential well or out of the reservoir of the MOS capacitance into the signal transfer path or to the horizontal signal line. This causes the whole vertical band to which the spot belongs seems to generate the signal. To prevent this phenomenon, the overflow signal charges are led to a separately provided overflow drain (OFD) or discharged to the substrate.

Smear is the phenomenon in which signal electrical charges are generated by scattered lights or lights penetrating into the substrate (where the lights are not necessarily strong), and they dissipate and enter adjacent signal transfer path.

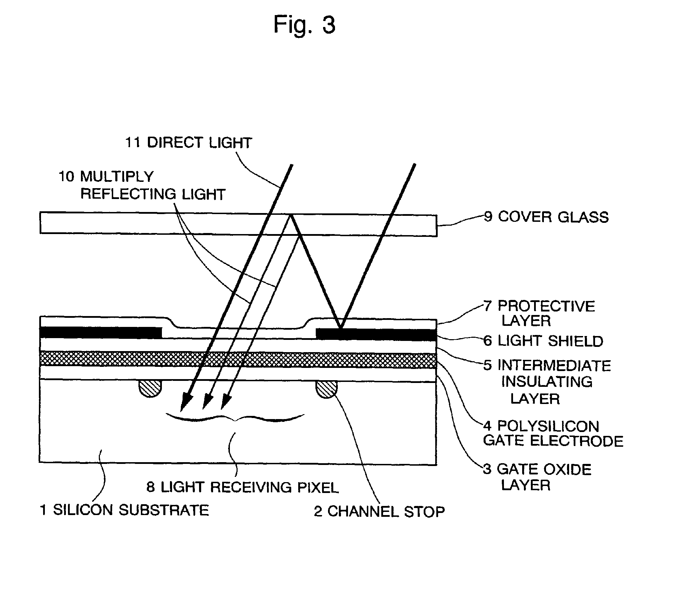

Fig. 3 shows a cross sectional view of a solid state imaging device at a light receiving pixel 8. On a p-type silicon substrate 1, a pair of channel stops 2 are formed for every channel. The surface of the silicon substrate 1 is oxidized to form a silicon oxide insulating layer which becomes the gate oxide layer 3. On the gate oxide layer 3 is formed a polysilicon gate electrode 4 made of polycrystalline silicon. Then an intermediate insulating layer 5 is formed, and a light shield layer 6 is formed. The light shield layer 6 has an aperture at every light receiving pixel 8 and shuts off light at the other parts including the accumulating pixels 23 (not shown). The top is covered by a thin transparent protective layer 7. The solid state imaging device is put in a case so that direct light 11 enters the light receiving pixels 8 through the cover glass 9.

The solid state imaging device functions as follows. The p-type silicon substrate 1 is grounded and the polysilicon gate electrode 4 is applied with a positive voltage. This drives the positive holes in the silicon downward to the bottom of the silicon substrate 1 so that the concentration of the holes in the surface decreases to form a depletion layer. When a higher positive voltage is applied to the polysilicon gate electrode 4, the lower end of the conduction band in the surface becomes lower than the Fermi level, which renders the inverted state in which free electrons can exist. This creates an n-channel between the silicon substrate (Si) 1 and the gate oxide layer (SiO₂) 3 in which free electrons exist. Since there are little free electrons in the p-type silicon substrate 1, a deep depression of potential (potential well) is formed in which little free electrons exist just after a voltage is applied. When, in such a state, free electrons are generated by an irradiation of light rays, the electrons are trapped in the potential well. As time passes, thermally excited electrons may also join the photo-induced electrons, and the potential well may become full of such electrons. In order to prevent such an occurrence, in the case of CCD, appropriate pulses are applied to the polysilicon gate electrodes 4 to form another well in the adjacent place and the electrons are moved to the second well. In this case, the electrons move not through the region between the gate oxide layer 3 and the silicon substrate1 but through a buried channel running in a shallow undersurface of the silicon substrate 1.

When the light coming from the picture object enters the light receiving pixel 8 (the light is referred to as the direct light 11), the light also falls onto the light shield 6 at other places. The light falling on the light shield 6 is reflected by its surface, and the reflected light is then further reflected by the top and bottom surfaces of the cover glass 9. Such multiply reflected light 10 also enters the light receiving pixel 8 with the direct light 11. Still other lights, such as those reflected many times in the cover glass 9, in the protective layer 7 or in the intermediate insulating layer 5, also enter the light receiving pixel 8. There lights (scattered lights) deteriorate the signal to noise (S/N) ratio.

Even if the light is not strong, the signal electrical charges generated by the scattered light or by the light that has penetrated deep into the substrate dissipate and flow into adjacent signal transfer path, which causes smear.

When a high-speed movie is taken, the exposure time is shorter than normal. In such a case, laser light is often used to illuminate the object with an adequate amount of light. In a high-speed movie, also, shadows or interference images of a laser illumination are sometimes used to detect small changes in the density of the picture object. In a conventional solid state imaging device, the light shield 6 covering most of the device has a high reflectivity, so that the multiply reflected light 10 interferes with the direct light 11 in entering the light receiving pixel 8, which creates unwanted interference fringes in the pictures.

### SUMMARY OF THE INVENTION

The present invention addresses the problem. That is, an object of the present invention is to provide a solid state imaging device in which such multiply reflected lights and scattered lights entering the light receiving pixels are minimized, allowing only the direct light to enter the light receiving pixels. This improves the S/N ratio and eliminates smears and unwanted interference fringes when a laser illumination is used.

According to the present invention, a solid state imaging device includes the features as recited in claim 1. Further advantageous features are recited in dependent claims 2-10.

The solid state imaging device of the present invention is a charge transfer type CCD including two-dimensionally arrayed light receiving pixels and at least two accumulating pixels provided to each of the light receiving pixels. The low reflectivity opaque cover, or the anti-reflection cover, has the same pattern as the light shield. Thus the incident light hardly reflects on the anti-reflection cover, and the harmful multiply reflecting lights are minimized. Further, the incident light hardly passes through the anti-reflection cover. Thus the light reflected by the light shield is absorbed by the anti-reflection cover so that no scattered light is produced. These improve the S/N ratio and prevents smears or interference fringes when laser illumination is used.

### BRIEF DESCRIPTION OF THE ATTACHED DRAWINGS

Fig.. 1 is a cross-sectional view of a part of a solid state imaging device embodying the present invention.

Fig. 2 is a plan view of a solid state imaging device including a three by three array of light receiving pixels and four accumulating pixels for each of the light receiving pixels.

Fig. 3 is a cross-sectional view of a part of a prior art solid state imaging device.

### DETAILED DESCRIPTION OF A PREFEERED EMBODIMENT

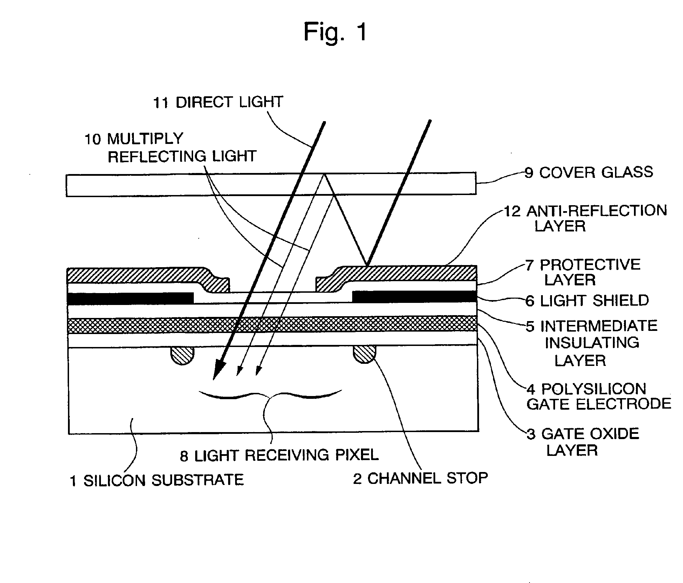

A solid state imaging device embodying the present invention is described using Figs. 1 and 2, where Fig. 2 shows, as described above, a conventional device having no anti-reflection layer 12.

The plan view or two-dimensional structure of the solid state imaging device of the present embodiment is the same as that of the prior art device shown in Fig. 2. That is, the device includes a three by three array of light receiving pixels 8; four accumulating pixels 23 (23a-23d) provided for each of the light receiving pixels 8; a vertical transfer path 24 provided for each of the light receiving pixels 8 and the accompanying accumulating pixels 23 (23a-23d); a horizontal transfer path 26; and an output amplifier 28. In each of the light receiving pixels 8, an incident light is converted to electrical charges according to the intensity of the light, and the signal electrical charges are accumulated in the accumulating pixels 23 (23a-23d) corresponding to the light receiving pixel 8. The signal charges in the accumulating pixels 23 (23a-23d) are transferred in the vertical direction 25 through the vertical transfer path 24 corresponding to the light receiving pixel 8, and then they are transferred in the horizontal direction 27 through the horizontal transfer path 26 toward the output amplifier 28.

As shown in Fig. 1, the solid state imaging device of the present embodiment is essentially composed of the following layers: a p-type silicon substrate 1; a pair of channel stops 2 for preventing an interference between adjacent channels; a gate oxide layer 3 of silicon oxide insulator made by oxidizing the silicon substrate 1; a polysilicon gate electrode 4 made of polycrystalline silicon; a thin, transparent and electrically insulated intermediate insulating layer 5; a light shield layer 6 having an aperture at each of the light receiving pixels 8; a protective layer 7 for protecting the surface; and an anti-reflection layer 12 for decreasing the multiply reflecting lights.

The solid state imaging device of the present embodiment differs from the conventional one in that the anti-reflection layer 12 is provided over the light shield layer 6 to decrease multiply reflecting lights.

The light shield layer 6 is formed on the surface of the intermediate insulating layer 5 and is made of the same metal material as the wiring of the device such as aluminum. The light shield layer 6 has apertures just above the light receiving pixels 8 and shuts off lights entering the accumulating pixels 23 (not shown in Fig. 1) and other parts. A thin, transparent protective layer 7 is formed on the light shield layer 6. Thus the direct light 11 enters only the light receiving pixels 8, and does not enter the accumulating pixels 23.

The anti-reflection layer 12 is made of such material that has a low surface reflectivity and a low transmissivity with respect to the incident light. For example, the material may be that used in the black layer for the filter array of a normal CCD. This greatly decreases the amount of light reflecting on the surface of or passing through the anti-reflection layer 12, and the influence of the light reflecting on the surface of the light shield layer 6 becomes negligible. Since the reflectivity of the surface of the anti-reflection layer 12 is low, the amount of multiply reflecting lights 10 (which are reflected between its surface and the surface of the cover glass 9 or other surfaces) and scattered lights (which are scattered from the reflected lights) becomes far less than that of the direct light 11. When, in the conventional structure, a strong light enters an aperture of the light shield layer 6, a part of the light escapes laterally within the intermediate insulating layer 5 and the protective layer 7 reflecting many times between the surfaces, and enters the accumulating pixels 23. This is apparently unfavorable since the structure is intended to protect the accumulating pixels from such light intrusion. Such unfavorable phenomenon can be avoided by extending the edges of the anti-reflective layers 12 toward the aperture, forming eaves on the edges of the aperture, as shown in Fig. 1. These extensions or eaves absorb such laterally escaping multiple-reflection lights, which improves the S/N ratio and decreases smears and interference fringes when laser illumination is used.

The solid state imaging device of the present embodiment functions as follows. The solid state imaging device is an FT-type three-by-three-pixel CCD with four frame transfer capacity. When light is cast on the device, it enters the low reflectivity anti-reflection layer 12 as well as the light receiving pixels 8. While the direct light 11 enters the light receiving pixels 8, other light falling on the anti-reflection layer 12 hardly reflects there and hardly pass through it. This minimizes multiply reflecting lights and scattering lights, and the light receiving pixels 8 receive only the direct light 11.

The signal electrical charges generated in a light receiving pixel 8 in each frame period are transferred to the accumulating pixel 23a placed just below the light receiving pixel 8 at the time the frame period finishes. At the same time, the signal electrical charges stored in the accumulating pixels 23a-23d are shifted downward to the adjacent pixels. After the shifts are carried out four times, the signal electrical charges generated in the first to fourth frames are stored in the accumulating pixels 23a-23d below the light receiving pixel 8 in the order of captured time. Then the solid state imaging device is covered with a shutter (not shown) to stop light entering the receiving pixel 8, and the signal electrical charges are transferred, similarly to normal FT-type CCDs, through the vertical path 24 and the horizontal path 26 to the output amplifier 28, where the signal electrical charges are converted to signal voltages. The signal voltages are read out externally, A/D converted and sent to a computer (not shown), so that images of the frames are reproduced.

In the above description of embodiment, an FT-type CCD is used. The present invention is also applicable to IT (interline transfer) type CCDs and FIT (frame interline transfer) type CCDs.

## Claims

1. A high-speed solid state imaging device comprising:
a plurality of two-dimensionally arrayed light receiving pixels (8) which generate electrical charges according to the incident light;
at least two accumulating pixels (23) for each of the light receiving pixels (8) for temporarily accumulating the electrical charges;
a transfer path (24) provided for each of a set of the accumulating pixels (23) corresponding to a light receiving pixel (8) for transferring the electrical charges temporarily accumulated in the accumulating pixels (23);
a light shield (6) for shutting off light entering the accumulating pixels (23) and the transfer paths (24) and having an aperture at each of the light receiving pixels (8); and
an opaque cover (12) having a low reflectivity and laid over the light shield (6) with an aperture at each of the light receiving pixels, wherein the opaque cover (12) extends into the aperture of the light shield (6) and forms an eave on the edge of the aperture of the light shield (6).

2. The solid state imaging device according to claim 1, wherein the opaque cover (12) further has a low transmissivity with respect to the incident light.

3. The solid state imaging device according to claim 1, wherein a protective layer (7) is laid between the light shield (6) and the opaque cover (12).

4. The solid state imaging device according to claim 1, wherein the opaque cover (12) is extended over an edge of the aperture of the light shield (6).

5. The solid state imaging device according to claim 1, wherein the solid state imaging device is an FT-type CCD.

6. The solid state imaging device according to claim 1, wherein the solid state imaging device is an IT-type CCD.

7. The solid state imaging device according to claim 1, wherein the solid state imaging device is an FIT-type CCD.

8. The solid state imaging device according claim 5, wherein the opaque cover (12) is made of the same material as that used in the black layer for the filter array of a normal CCD.

9. The solid state imaging device according claim 6, wherein the opaque cover (12) is made of the same material as that used in the black layer for the filter array of a normal CCD.

10. The solid state imaging device according claim 7, wherein the opaque cover (12) is made of the same material as that used in the black layer for the filter array of a normal CCD.

## Patentansprüche

1. Hochgeschwindigkeitsfestkörperbildaufnahmevorrichtung mit:
einer Vielzahl von zweidimensional gruppierten Lichtempfangsbildpunkten (8), die elektrische Ladungen nach Maßgabe des einfallenden Lichtes erzeugen;
wenigstens zwei Speicherbildpunkten (23) für jeden der Lichtempfangsbildpunkte (8) zum zeitweisen Speichern der elektrischen Ladungen;
einem Übertragungsweg (24), der für jede Gruppe von Speicherbildpunkten (23), die einem Lichtempfangsbildpunkt (8) entsprechen, vorgesehen ist, um die zeitweise in den Speicherbildpunkten (23) gespeicherten elektrischen Ladungen zu übertragen;
einer Lichtabschirmung (6) zum Unterbrechen des Lichtes, das in die Speicherbildpunkte (23) und die Übertragungswege (24) einfällt, die eine Öffnung an jedem Lichtempfangsbildpunkt (8) hat; und
einer lichtundurchlässigen Abdeckung (12) mit niedrigem Reflexionsvermögen, die über der Lichtabschirmung (6) mit einer Öffnung an jedem Lichtempfangsbildpunkt liegt, wobei sich die lichtundurchlässige Abdeckung (12) in die Öffnung der Lichtabschirmung (6) erstreckt und einen Überstand am Rand der Öffnung der Lichtabschirmung (6) bildet.

2. Festkörperbildaufnahmevorrichtung nach Anspruch 1, bei der die lichtundurchlässige Abdeckung (12) weiterhin einen niedrigen Transmissionsgrad bezüglich des einfallenden Lichts hat.

3. Festkörperbildaufnahmevorrichtung nach Anspruch 1, bei der eine Schutzschicht (7) zwischen der Lichtabschirmung (6) und der lichtundurchlässigen Abdeckung (12) liegt.

4. Festkörperbildaufnahmevorrichtung nach Anspruch 1, bei der sich die lichtundurchlässige Abdeckung (12) über den Rand der Öffnung der Lichtabschirmung (6) hinaus erstreckt.

5. Festkörperbildaufnahmevorrichtung nach Anspruch 1, bei der die Festkörperbildaufnahmevorrichtung eine FT-CCD ist.

6. Festkörperbildaufnahmevorrichtung nach Anspruch 1, bei der die Festkörperbildaufnahmevorrichtung eine IT-CCD ist.

7. Festkörperbildaufnahmevorrichtung nach Anspruch 1, bei der die Festkörperbildaufnahmevorrichtung eine FIT-CCD.

8. Festkörperbildaufnahmevorrichtung nach Anspruch 5, bei der die lichtundurchlässige Abdeckung (12) aus dem gleichen Material besteht, das in der Schwarzschicht für die Filteranordnung einer normalen CCD verwandt wird.

9. Festkörperbildaufnahmevorrichtung nach Anspruch 6, bei der die lichtundurchlässige Abdeckung (12) aus dem gleichen Material besteht, das in der Schwarzschicht für die Filteranordnung einer normalen CCD verwandt wird.

10. Festkörperbildaufnahmevorrichtung nach Anspruch 7, bei der die lichtundurchlässige Abdeckung (12) aus dem gleichen Material besteht, das in der Schwarzschicht für die Filteranordnung einer normalen CCD verwandt wird.

## Revendications

1. Dispositif imageur à semi-conducteurs à grande vitesse comprenant :
une pluralité de pixels récepteurs de lumière en matrice bidimensionnelle (8) qui génèrent des charges électriques selon la lumière incidente ;
au moins deux pixels d'accumulation (23) pour chacun des pixels récepteurs de lumière (8) pour accumuler temporairement les charges électriques ;
une voie de transfert (24) prévue pour chacun d'un ensemble des pixels d'accumulation (23) correspondant à un pixel récepteur de lumière (8) pour transférer les charges électriques accumulées temporairement dans les pixels d'accumulation (23) ;
un pare-lumière (6) pour couper la lumière entrant dans les pixels d'accumulation (23) et les voies de transfert (24) et ayant une ouverture au niveau de chacun des pixels récepteurs de lumière (8) ; et
un couvercle opaque (12) ayant une faible réflectivité et disposé par-dessus le pare-lumière (6) avec une ouverture au niveau de chacun des pixels récepteurs de lumière, dans lequel le couvercle opaque (12) s'étend dans l'ouverture du pare-lumière (6) et forme un avant-toit sur le bord de l'ouverture du pare-lumière (6).

2. Dispositif imageur à semi-conducteurs selon la revendication 1, dans lequel le couvercle opaque (12) a en outre une faible transmissivité en ce qui concerne la lumière incidente.

3. Dispositif imageur à semi-conducteurs selon la revendication 1, dans lequel une couche protectrice (17) est disposée entre le pare-lumière (6) et le couvercle opaque (12).

4. Dispositif imageur à semi-conducteurs selon la revendication 1, dans lequel le couvercle opaque (12) s'étend par-dessus un bord de l'ouverture du pare-lumière (6) .

5. Dispositif imageur à semi-conducteurs selon la revendication 1, dans lequel le dispositif imageur à semi-conducteurs est un CCD de type à transfert de trames.

6. Dispositif imageur à semi-conducteurs selon la revendication 1, dans lequel le dispositif imageur à semi-conducteurs est un CCD de type à transfert d'interlignes.

7. Dispositif imageur à semi-conducteurs selon la revendication 1, dans lequel le dispositif imageur à semi-conducteurs est un CCD de type à transfert d'interlignes de trames.

8. Dispositif imageur à semi-conducteurs selon la revendication 5, dans lequel le couvercle opaque (12) est fait du même matériau que celui utilisé dans la couche noire pour la matrice de filtre d'un CCD normal.

9. Dispositif imageur à semi-conducteurs selon la revendication 6, dans lequel le couvercle opaque (12) est fait du même matériau que celui utilisé dans la couche noire pour la matrice de filtre d'un CCD normal.

10. Dispositif imageur à semi-conducteurs selon la revendication 7, dans lequel le couvercle opaque (12) est fait du même matériau que celui utilisé dans la couche noire pour la matrice de filtre d'un CCD normal.
